# EUROPEAN PATENT SPECIFICATION

(11) **EP 2 385 563 B1**
(45) Date of publication and mention of the grant of the patent: **02.11.2016**
(21) Application number: 10425146.7
(22) Date of filing: 03.05.2010
(51) Int. Cl.: H01L 51/10, G01N 27/414, B82Y 10/00, H01L 51/30

(54) **Organic field effect transistors based on multilayers of self-assembled biological systems covered by an organic semiconductor layer and sensor thereof.**
Organischer Feldeffekttransistor basierend auf selbstorganisierten biologischen Mehrschichtsystemen bedeckt von einer organischen Halbleiterschicht und Sensor damit.
Transistor à effet de champ basé sur des multicouches de systèmes biologiques auto-assemblés recouverts d'une couche semiconductrice organique et capteur comprenant ce transistor.

(43) Date of publication of application: 09.11.2011
(73) Proprietor: Universita' degli Studi di Bari, 70121 Bari (IT); Consiglio Nazionale Delle Ricerche, 70126 Bari (IT)
(72) Inventor: Torsi, Luisa, 70126 Bari (IT); Palazzo, Gerardo, 70126 Bari (IT); Cioffi, Nicola, 70126 Bari (IT); Angione, Maria Daniela, 70126 Bari (IT); Magliulo, Maria, 70126 Bari (IT); Cotrone Serafina, 70126 Bari (IT); Scamarcio Gaetano, 70126 Bari (IT); Sabbatini Luigia, 70126 Bari (IT); Mallardi Antonia, 70126 Bari (IT)
(74) Representative: De Bonis, Paolo

(56) References cited:
- WO-A1-00/51191
- WO-A1-03/014722
- DE-A1- 10 226 945
- DE-A1- 19 721 698
- ZAMMATTEO NATHALIE ET AL: "Comparison between different strategies of covalent attachment of DNA to glass surfaces to build DNA microarrays", ANALYTICAL BIOCHEMISTRY, ACADEMIC PRESS INC, NEW YORK, vol. 280, no. 1, 10 April 2000 (2000-04-10), pages 143-150, XP002159089, ISSN: 0003-2697, DOI: DOI:10.1006/ABIO.2000.4515
- MORITA T ET AL: "Ambipolar Transport in Bilayer Organic Field-Effect Transistor Based on Poly(3-hexylthiophene) and Fullerene Derivatives", JAPANESE JOURNAL OF APPLIED PHYSICS, JAPAN SOCIETY OF APPLIED PHYSICS, JP, vol. 49, no. 4, 1 April 2010 (2010-04-01), pages 41601-1, XP001553996, ISSN: 0021-4922, DOI: DOI:10.1143/JJAP.49.041601 [retrieved on 2010-04-20]
- PETER PACHER ET AL: "Chemical Control of Local Doping in Organic Thin-Film Transistors: From Depletion to Enhancement", ADVANCED MATERIALS, vol. 20, no. 16, 18 August 2008 (2008-08-18), pages 3143-3148, XP055018614, ISSN: 0935-9648, DOI: 10.1002/adma.200800058

## Description

The object of the present invention consists of innovative **organic** field effect transistors (OFET) as described in Claim 1. Further, the present invention relates to label-free, selective and sensitive sensors, as described in Claim 8, for detecting volatile or liquid substances for example of interest in biomedical field. Examples of FET transistors used as sensors can be found, e.g., in DE-A-10226945 and PETER PACHER ET AL: "Chemical Control of Local Doping in Organic Thin-Film Transistors: From Depletion to Enhancement", ADVANCED MATERIALS, vol. 20, no. 16, 18 August 2008 (2008-08-18), pages 3143-3148, XP055018614, ISSN: 0935-9648.

Several sectors in analytical chemistry, such as, for instance food analysis, environmental monitoring and clinical diagnostics, displayed a strong interest toward the development of devices to be directly used in on-field applications. For example, the concept of POC (Point Of Care) analysis refers to the possibility to perform diagnostic procedures, in an accurate and rapid way, directly in the place where they are needed (doctor's office, private hospital). Of course, the analytical systems for such applications must be easy to use and provide easily readable outputs/responses and quantitative data. In this regard, biosensors being capable to perform fast analysis and label-free detection, have been proven to be very promising since they are able to directly probe a biological recognition event without the need of a marker. Recently, attention was directed to the development of immunosensors and genosensors offering a fast, continuous and *in situ* detection as well as a quantification of analytes in complex matrices such as blood. Such biosensors exploit specific immunologic (antigen/antibody binding) or nucleic acid hybridization (binding of complementary sequences) reactions for identification and quantification of analytes, using a proper transduction signal which can be an optical, electrochemical, or electronic one. In particular, immunosensors, in comparison to other analytical methods, present the following advantages: they are selective and sensitive, they can be used for on field analysis, they can be fully automated, the response can be fast and the analytes do not need to be purified or treated before the analysis. However, a lot of presently developed biosensors present several disadvantages in terms of cost, reagents availability, regeneration and reproducibility. Moreover, the sensor sensitivity is markedly influenced by the transduction mechanism and, today, only few satisfactory performing biosensors are available on the market. Hence, the need arises to have fast, reliable, accurate, portable and low cost biosensors.

Although presently only some preliminary studies have been performed, OFETs present interesting characteristics to be successfully employed as label-free biosensors. The OFET sensor field has been rising a great attention in the last decade. This is mostly due to the possibility to implement such devices in high performance portable detection systems. One of the sensor market' major request is the possibility to have devices capable of detecting, biological and chemical analytes, on-line and *in situ.* Such devices can be employed in a wide range of applications ranging from food and beverage control, to medical diagnostic and public security. Such requirements are not still completely fulfilled by the technology supporting the sensors currently on the market. The selectivity, the capability to work at room temperature and the high sensitivity to a wide range of analytes are still open questions in the field and, in this respect, OFETs have shown the capability to overcome some of these limits. As a matter of fact they behave as multi-parameter sensors, display a high repeatability, a fast and reversible response, can work at room temperature, display a good selectivity toward a wide range of analytes, and allow on-state analyte detection and amplified sensitivity as the applied gate bias is increased. Furthermore, the bilayer architecture OFET sensor, recently proposed, appears to be of great interest for high performance analysis of chiral analytes. The bilayer structure has been engineered combining field effect transistors with chiral recognition properties, allowing a differential enantiomeric detection of volatile analytes at unprecedented low concentration, namely in the ppm range. Biological recognition measurements are usually performed in aqueous media and low voltage transistors are able to assure stable working conditions in such an environment. Water electrolysis and high ionic analyte conductivity represent, indeed, the main drawbacks to overcome for applications in an aqueous environment. New organic and inorganic dielectrics have been recently developed to lower OFET threshold bias and to invert the slope below the threshold voltage, both responsible for the high OFET voltages. Such figures of merit depend also on gate dielectric properties. This implies the development of high capacity thin gate dielectrics, one of the main challenges of organic electronics. The immobilization of biomolecules, such as DNA, enzymes or other proteins, on sensor surface represents a new basic research area involving different interdisciplinary fields. The development of new structures which are capable to provide a direct link between the complex world of biology and digital electronics is a target of scientific research worldwide. The choice of the method of bioprobe immobilization allowing a specific biomolecule to retain its biological function is one of the most important aspects in biosensor fabrication. To obtain a biorecognition reaction which is selective, sensitive and reproducible, it is necessary to immobilize the biomolecules on the surface to obtain well oriented molecular layers. Further, to increase sensitivity it is essential to reduce the distance between the transduction surface and the layer of immobilized biomolecules. The biomolecules can be immobilized on a sensor surface in different ways. For immobilization purpose, several materials can be used such as for instance nafion, sol-gel, lipid membranes, conductive polymers or self-assembled monolayers (SAMs). SAMs are particularly suitable as biosensor active layer since they form thin, ordered and stable monolayers and they can be grafted on the surface thanks to the wide headgroup availability. Further, they can provide to biomolecules a microenvironment similar to that of the membranes and require only minimal quantities of often very expensive biomolecules. Another alternative method consists in the use of electrosynthesized conductive polymers as matrices for immobilizing biocomponents. From the scientific literature and in particular as a consequence of the important work of the researchers Foulds and Lowe published in 1988, the immobilization of biomolecules such as enzymes, DNA, antibodies and even whole cells in conductive polymers was studied for manufacturing biosensors, including immunosensors. Among all conductive polymers studied to date, polypyrrole (PPy) can be considered one of the most interesting materials for its excellent conductivity, stability and biocompatibility even at neutral pH. In addition to PPy and its derivatives the use of conductive polymers such as poly(aniline), poly(3-hexylthiophene), poly(o-aminobenzoic acid) has been studied for the realization of immunosensors. Recently attention has been directed to the use of systems mimicking cell membranes for immobilizing biomolecules. The low bioactivity of membranes renders them particularly interesting as an interface between the not biological material on sensor surface and the biologically active fluids. Lipid membranes represent also a natural environment for biological molecules. Thanks to the natural environment, it is possible to prevent biomolecule denaturation and to obtain high sensitivity and selectivity. Furthermore, low membrane bioactivity prevents signal interferences, while active biomolecule localization on a surface favours signal transduction. The membranes can be deposited on a surface in several ways. In particular, sensor surface can be modified introducing binding sites specific for lipid molecules in order to deposit steadily the membranes. The configuration of the devices to be developed combines high selectivity of bio-recognition with the high sensitivity typical of the electronic transduction offering high analytical performances. Such devices do not require large sample volumes or toxic solvents for the analysis, they are characterized by minimal sample pretreatment and low reagent consumption, present high specificity, in the analysis of complex matrices too, and can be readily miniaturized and automatized in portable and disposable devices.

Furthermore, configurations of devices presenting a layer of a biological recognition system between the dielectric and the organic semiconductor, which represents the peculiarity and the innovation of this specific invention, have never been proposed before.

All devices object of the present invention can function as electronic sensors and can be realized by techniques developed in the framework of organic electronics. The main advantages are:
- OFET sensors allow label-free detection; in fact it is not necessary to label the sample by attaching fluorescent or electroactive markers to the species to be analyzed;
- single devices, as well as matrix systems (array), are miniaturizable and realizable with low cost screen-printing technologies and on substrates made of plastic, paper or even fabrics;
- they do not need a reference electrode to measure the current changes induced by the interaction with the species to be detected.

Currently available sensors for the suggested detections, for example those with optical or electrochemical detection, fail to fulfil at least one of the above listed characteristics.

These and other advantages will be better highlighted in the detailed description of the invention which specifically refers to tables 1/4, figures 1 to 8, in which an example absolutely not limiting of a preferred realization of the present finding is exposed. In particular:
- figure 1 shows the OFET sensor structure made of an active material comprising a biological layer of type (a), (b), (c), (d) or (e), as reported in detail at page 11, covered by an organic semiconductor, for example poly-3-hexyl-thiophene (P3HT); in the figure the organic semiconductor OS (1), the self-assembled biological layer SBL (2), the dielectric (3), the conductive substrate (4), the channel region (5), the active material (6) and the analyte (7) are displayed;
- figure 2 shows the curve of the micro-luminescence spectra of a phospholipidic layer, properly labelled with Texas-Red fluorophore, the P3HT and the multilayer made of phospholipids on which P3HT was deposited. Both the phospholipidic and the P3HT layer were deposited by spin-coating;
- figure 3 shows: (a) the curves of the current-voltage characteristics (IDS vs. VDS at different VG values) of a P3HT OFET; (b) transfer characteristics of the same device (IDS vs. VG at VDS = -30 V);
- figure 4 shows the curves of current- voltage characteristics of an OFET made of a phospholipidic layer covered by a P3HT layer;
- figure 5 shows the transfer characteristics curves of sensor 1 exposed to an inert gas (N₂) atmosphere and to ethyl-ether. Sensor response is defined by the difference between IDS values (measured in N₂ and in the analyte atmosphere) at a fixed VG potential;
- figure 6 shows the graph of the calibration curve of sensor 1 and the control device (P3HT OFET) exposed to a controlled atmosphere of ethyl-ether or acetone. Each data point is the result of three measurements and the error bars are the mean standard errors;
- figure 7 shows the transfer characteristics curves obtained for OFET functionalized with streptavidin exposed to water (solid line curve - streptavidin + P3HT / H₂O), OFET functionalized with streptavidin exposed to biotin (short dashed line curve-streptavidin + P3HT / biotin). Dotted and long dashed line curves are referred to the two negative control experiments.

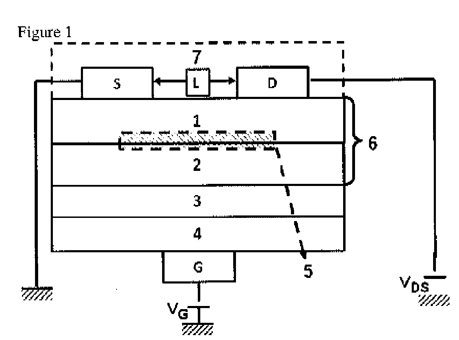

The devices described in the present finding have a structure of a field effect or similarly of an organic thin film transistor (OFET) as displayed in figure 1. The transistor is fabricated starting from a highly doped silicon substrate (resistivity 0.02-1 Ohm/cm) acting as gate material. It is also possible to use a metallized glass slide or a flexible plastic substrate but also paper or fabric substrate. In the present case the doped silicon wafer is covered by a SiO₂ layer (thickness 100 nm or 300 nm) acting as a dielectric. The suggested procedures can be readily extended also to other oxides such as TiO₂ or polymeric dielectrics provided that they are properly treated in order to hold -OH type functionalities allowing the anchoring of the biological layer. Dielectric thickness and material dielectric constant determine the bias necessary to operate the device. In the exposed case bias are as high as -100 V (-40 V for 100 nm thick SiO₂) but examples in literature show that OFETs, also used as sensors, can be operated at bias lower than 1 Volt. Before device fabrication, a cleaning step of the dielectric surface is always performed, it includes: washing in H₂O, followed by washing in acetone and again H₂O; sonication in isopropanol for 10 minutes; sonication in methanol for 10 minutes; again H₂O - acetone - H₂O. It is generally convenient to perform a washing treatment with solvents at increasing polarity and even a treatment with oxygen plasma followed by an activation step of the oxide, aimed at increasing the number of polar groups (-OH) on substrate surface. This last step is performed using a solution composed of sulphuric acid and hydrogen peroxide (piranha) or UV treatment with ozone. The innovative aspects of the device, object of the present patent is the presence of a biological layer deposited directly on the dielectric surface. The possible biological systems include:
- (a) single or double phospholipidic layers;
- (b) layers composed by proteins such as: receptors, antibodies, ionic channels and enzymes;
- (c) single or double phospholipidic layers with inclusion or anchoring of the proteins listed at point (b);
- (d) layers composed by oligonucleotide (DNA, RNA, PNA) probes;
- (e) layers composed by cells or viruses;
- (f) layers composed by synthetic receptors (molecules or macromolecules similar to biological receptors for properties, reactivity or steric aspects).

Biological systems can be covalently bound or otherwise adhered (physical adsorption, spin-coating) to the dielectric.

An organic semiconductor, such as for example oligomers or polymers of thiophene, also substituted with alkyl chains, oligoacenes such as pentacene, tetracene or anthracene, phthalocyanines, porphyrins but even naphthalenes, fullerenes, etc., is deposited on top of the deposited biological layer. Indeed, both p and n organic semiconductors can be used. The organic semiconductor can be deposited from a solution (spin-coating or drop-casting), in the case of soluble materials or by thermal evaporation in the case of not soluble materials. In this specific case a p-type organic semiconductor is deposited by spin-coating. Specifically the poly(3-hexylthiophene-2,5-diyl - P3HT) (Sepiolid P 200, supplied by Basf) was dissolved in chloroform at a concentration of 2,6 mg/ml. The commercial material was purified following a procedure of subsequent washing in a soxhlet apparatus with methanol and hexane. The deposition of purified P3HT was performed by spin-coating at a spin rate of 2000 rpm 30 sec long.

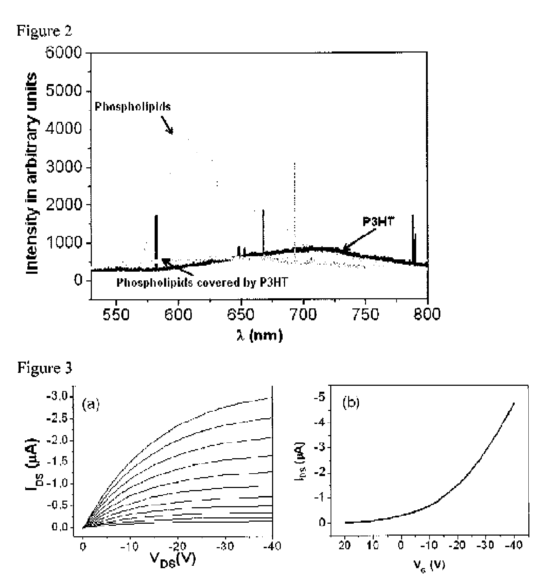

The present invention proposes, for the first time, an OFET comprising a biological layer directly at the interface with the channel region. This configuration has the capability to provide an OFET device with better electronic properties and higher performances, particularly in terms of sensitivity, since the recognition event of the analyte takes place where the bidimensional charge transport (field effect) responsible of current amplification occurs. The device structure is shown in figure 1. All the deposited biological layers, as well as all the active multilayers (meaning the biological layer covered by the organic semiconductor), underwent an extensive surface and volume spectroscopic characterization. Surface characterization was performed through X rays photoelectronic spectroscopy (XPS), used in conventional, angle resolved (ARXPS), and imaging (map-scan XPS) mode. The first operative mode was employed to get general information about the composition and chemical speciation of the surface. The ARXPS mode was used as a not destructive study of element and functional group distribution in a thin layer corresponding to about 5 nm of the most external surface portion. Further, ionic controlled erosion (ion-beam assisted depth-profiling XPS) was adopted to explore layers of higher thickness. In both cases for the reconstruction of the concentration profiles, target elements, such as phosphorus, sulphur, nitrogen, were chosen to identify the presence of single multilayer component and an advanced XPS data analysis software was subsequently employed to obtain the elicited profiles. Finally, the analysis performed in imaging-XPS mode with a resolution corresponding to about 20 µm, allowed to verify the uniformity of the multilayers surface. Volume characterization was performed too by micro-luminescence technique on both the single P3HT and on the multilayers. As an example the case of the sample including the phospholipidic layer is reported. Figure 2 shows the luminescence spectra excited with the 476 nm line of a Kripton laser.

In such figure 2 the micro-luminescence spectra of just the phospholipids film deposited through spin-coating from an aqueous solution (further details are reported in the section dedicated to example 1) are compared; this spectrum is particularly intense since fluorophore (Texas-Red) labelled phospholipids have been used. A luminescence signal can be recorded also for the bare P3HT film, even though less intense and red shifted. The characterization proceeded with the measurement of a sample fabricated by depositing the phospholipidic layer covered by a P3HT layer. This latter layer was deposited by spin-coating from a chloroform solution (example 1). It is evident that the luminescence line shape of the phospholipidic layer covered by the organic semiconductor, shows contributions from both the phospholipid and the organic semiconductor stacking layers. This confirms that P3HT deposition does not remove the biological layer deposited underneath. This is a critical information that supports the interpretation of the results, shown in the following, obtained using this system as a sensor. The structure was confirmed also by morphological measurements performed by atomic force scanning microscope. Manufacturing of OFET device was then completed by depositing the source (S), drain (D) and gate (G) contacts by thermal evaporation (8 x 10⁻⁷ torr) of gold through a shadow mask. This method of OFET manufacturing is compatible with screen-printing technologies allowing device realization, even in array configuration, at low cost and allows implementing them on plastic, paper or even fabric substrates. The geometry used to define the S and D contacts results in rectangular pads that can be spaced by 1 to 500 µm; this spacing is addressed as "L" (figure 1) being the channel length. The S and D contacts can be also be deposited directly on the dielectric layer just after surface cleaning procedure. The device is operated in the common source configuration. Because of the capacitive coupling effect between dielectric and active material (performed by biasing the gate contact respect to the grounded source), it is possible to tune the current passing between source and drain. The charge induced by the gate field is confined, because of field effect, to a bidimensional region, called in fact the channel region, at the interface with the dielectric. OFET devices, including a biological active layers as reported in figure 1, were used as sensors by first measuring the electrical behaviour of the device composed by the P3HT film only. Typical current voltage characteristics (I-V) are reported in figure 3. In particular figures 3(a) shows the I-V characteristics obtained measuring the IDS current flowing between S and D as a function of the VDS bias at different gate biases, VG. In figure 3(b) the IDS current curves as a function of VG bias at constant VDS (-40 V) are reported. Such curves are called transfer characteristics. The data analysis, performed according to consolidated procedures results for the device in figure 3 in a field effect mobility, µFET, of 5x10⁻³ cm²/Vs, Ion/Ioff = 10, and threshold voltage, Vt, of 7 V.

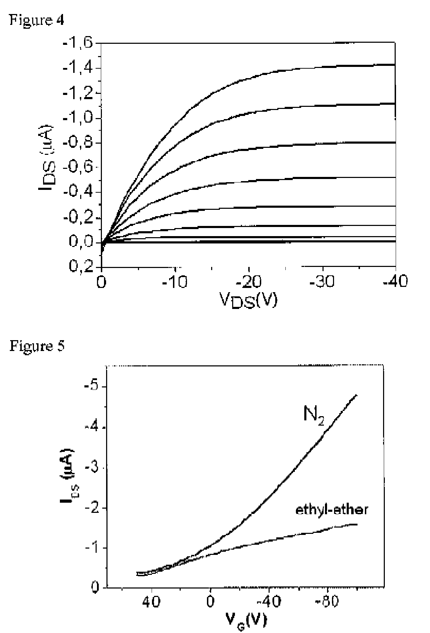

The current-voltage characteristics of an OFET, fabricated depositing a P3HT layer on top of a phospholipidic layer as previously described are reported in figure 4. It is interesting to note that also the device including the phospholipid layer covered by the P3HT films works beautifully as transitor. In particular, µFET, of 6.25x10⁻³ cm²/Vs, Ion/Ioff = 100, which is in line with the best performing P3HT devices. Even more striking is the fact that figure of merits such as the amplification ratio (Ion/Ioff), even improved with the introduction of the phospholipidic layer. It is the first time that an OFET comprising a biological layer at the interface between the organic semiconductor and the gate dielectric is realized and proven to work at such high level of performances. In this case the electronic characteristics are even better for the OFET comprising the biological layer.

Both the bare P3HT OFET devices as well as the OTFT comprising the multilayer (including the biological layer as in figure 1) were then exposed to the analyte. For both devices the transfer characteristics were measured upon exposure of the channel region to the analyte to be detected. The transfer characteristics current changes before and after the exposure is taken as the sensor response. Furthermore, ad hoc designed control experiments (blank measurements) were performed as described in details in the examples reported (vide infra). To perform the sensing experiments, different procedures were used for the detection of volatile and liquid substances.

### Procedure 1: determination of volatile analytes

A controlled concentration flow of the analyte was obtained by bubbling the inert carrier gas, N₂, into two bubblers containing the analyte in its liquid form. This allows to obtain a nitrogen flow having a partial pressure of the analyte vapours equal to the pressure of saturated vapour of the same analyte at the working temperature of the analysis. To increase the saturation efficiency, besides the trap, the two bubblers were used in series. The temperature was controlled and kept constant by dipping the bubblers in a cryothermostat. Flow control is achieved through a system of two computer controlled flowmeters (Brooks Smart DMFC model 5850C). The described experimental apparatus, allows to control independently and simultaneously the flow of the carrier gas and that of the nitrogen saturated with the analyte. Analyte concentrations sent on the sample can be changed with subsequent dilutions obtained by changing the rate of the two flows.

### Procedure 2: determination of bio-analytes in water

To perform the bio-sensing measurements in water, the solution containing the analyte was deposited directly on the organic semiconductor and incubated long enough to allow both the diffusion of analyte through the organic semiconductor layer and the binding with the element deputed to biological recognition. Subsequently, the not bound excess analyte was removed by washing and the device was dried under a nitrogen flow. Examples of realizations of two specific OFET sensors used for different applications are reported in the following:

### Example 1 - Manufacturing and functioning of sensor 1

In this case, the OFET was realized using phospholipids layer as biological system. This device is proposed as a sensor for anaesthetics. The device sensitivity to anaesthetic substances such as halothane and diethyl-ether resulted an order of magnitude higher than that to other organic vapours, with the same volatility, such as acetone or isopropanol. This is particularly interesting also because it is very difficult to selectively detect organic substances with the same volatility by means of a chemical sensor.

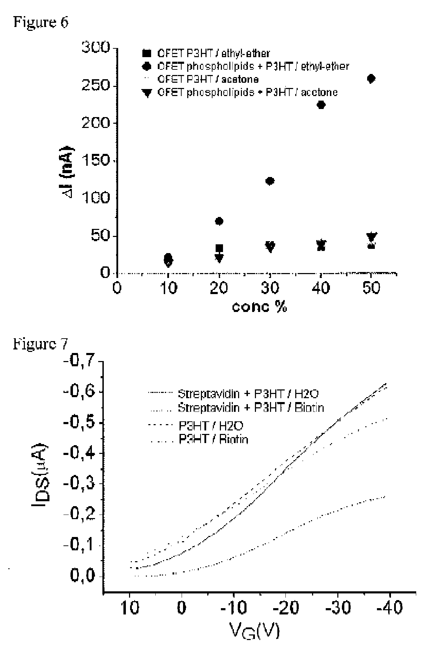

The device was realized as follows. A layer of phospholipids was deposited, on a properly washed and treated SiO₂ surface, by starting from an aqueous suspension of single unilamellar vesicles (SUV). The suspension was realized dissolving 10 mg of soybean lecithin (EPIKURON 200, Cargill) in chloroform allowed to evaporate under vacuum, afterword. The phospholipids were suspended in 1 ml of distilled water and sonicated on ice for 30 minutes. Then, the obtained multilamellar vesicles suspension was repeatedly subjected to extrusion using a polycarbonate filter having pore sizes of 100 nm, to obtain evenly dimensionally distributed unilamellar phospholipidic vesicles. 50 µl of this solution were deposited on the Si/SiO₂ substrate, subjected then to a rotation of 200 rpm for twenty minutes. Similarly but on a different device, also a film known as "purple membranes" constituted by the bacteriorhodopsin membrane protein and lipids was deposited. Even in this case, the deposition was performed by spin-coating from a "purple membranes" suspension in H₂O. Atomic force scanning micrographies (AFM) show how such spin coating procedure at a very slow rotation results in a multilayer of phospholipids made of flat surfaces with a very smooth and even surface. P3HT is subsequently deposited again by spin-coating but from chloroform directly on the phospholipidic film as well as on the "purple membranes". The measurements reported in figure 2 show that the deposition of the organic semiconductor does not remove the phospholipidic film. AFM measurements evidenced in fact that the phospholipidic layer deposited by spin coating from water is not removed when bare chloroform is spun over it. The result of such an experiment is a drastic reduction of thickness which goes down to few nanometer and the surface becomes much more even and extremely flat. The comparison between the transfer characteristics of sensor 1 exposed to an inert gas (N₂) and to a flow of 40% ethyl-ether in N₂ is outlined in figure 5. It is evident that ethyl-ether causes a remarkable decrease of the current flowing in the channel region. Similar results were obtained with an anaesthetic still in use such as halothane. In this case the measured responses are in the range of clinical concentrations (2-4 % in N₂) useful for real applications. An even higher and opposite sign response was obtained substituting the simple phospholipidic layer with a "purple membranes" which is known to contain in addition to phospholipids also bacteriorhodopsin. In fact, in this case the exposure to the anaesthetic causes a current increment. Being P3HT a p-type semiconductor the current increment is to be ascribed to the injection of H⁺ ions in the bidimensional transport region of the transistor, as it is foreseen by the conformational change of bacteriorhodopsin. This result is particularly remarkable since it demonstrates how it is possible to integrate a membrane protein in an OFET to build a sensor. But it is even more important that the protein continues to work and the transistor allows performing an electronic detection of a conformational change. The calibration curves of sensor 1, containing just the phospholipidic layer, when exposed to both ethyl-ether and another organic vapour of comparable volatility (acetone) are shown in figure 6. The response ΔI reported on the abscissa is the change of IDS following the exposure to the analytes vapours respect to the value in N₂. Both values are taken at VG = -40 V. For comparison, an OFET with only P3HT was exposed to the same substances. The calibration curves of figure 6 evidence how the response to ethyl-ether is about a factor 10 higher for the OFET including the phospholipidic layer respect to the control device. Instead, it is interesting to note that the exposure to acetone vapours does not cause an important effect neither in sensor 1 and nor in the control device. It is also interesting to observe that exposure of the same devices to an alcohol such as isopropanol displayed a similar behaviour to that of acetone. The response of the P3HT OFET to isopropanol is slightly higher than foreseen probably because of the swelling effect of the organic semiconductor favoured by interactions between the alkyl chains. A similar effect has been already proven in the past. The mechanisms by which molecules such as ether, halothane, desflurane or nitrogen protoxide, are able of induce a state of general anaesthesia are not, as yet, fully understood. One of the most accredited theories however foreseen the involvement of just the interactions between the anaesthetic molecules and cell membranes even if it is not clear if the presence of any specific receptors is required. Although these studies evidence the peculiarity of the interactions between anaesthetics and membranes, it was never thought before to employ a phospholipidic bilayer as an active material in a sensor for such substances. A sensor with an organic thin film transistor (OTFT) configuration is particularly suitable to the aim, not only for the already proven high sensitivity, but mostly because it exploits an interface phenomenon, such as the field effect, to induce the electronic response. The synergic effect of these two factors, coupled for the first time in a sensor, generates a device potentially useful for monitoring anaesthetic substances with an interesting degree of selectivity, good sensitivity and excellent reproducibility. The low manufacturing costs and the possibility to miniaturize the devices based on a soluble organic semiconductors are further advantages of the system object of this invention. The methods adopted for the realization of sensor 1 can be readily extended to the realization of a sensor comprising the biological system (c) which includes any one of the proteins of which at point (b) or (f). The realization procedure of the device foresees the deposition of double phospholipidic layers which includes membrane proteins (such as receptors, ionic channels or enzymes of different kind), starting from proteoliposomes, or better vesicles containing in the double lipid layer the proteins of interest. Proteoliposomes are prepared by molecular exclusion chromatography (micelles mixed with phospholipids, detergent and protein in proper ratios, are filtered on Sephadex G-50 columns) and are subsequently deposited on the dielectric layer of the device. It is widely reported in literature that, after deposition on a solid substrate, spontaneous melting of the vesicles occurs simultaneously to adsorption of the double layer on the substrate. The case of "purple membranes" previously discussed is only one of the possible examples. In presence of soluble proteins such as antibodies the deposition strategy foresees anchoring of the protein to a double lipid layer deposited as previously described. But in this case, lipids functionalized with amino or carboxylic groups to which the antibody can be covalently bound through bioconjugation procedures reported in literature and employing the EDC / Sulpho-NHS system have to be used.

### Example 2 - Manufacturing and functioning of sensor 2

In this case the OFET sensor was fabricated using the streptavidin-biotin system as model. Streptavidin was immobilized on the dielectric layer by physical adsorption, spin-coating and chemical binding. The fabrication steps of the biomolecule immobilization on the OTFT sensor surface are reported in the following. The procedures optimized for the specific reported case of streptavidin can be readily extended to OFETs realized with the other protein classes mentioned at point (b) as well as with biological systems reported at points (d) and (e) and from synthetic receptors as reported at point (f). Immobilization of streptavidin by physical adsorption was performed incubating the Si/SiO₂ substrates, previously washed and activated, with a streptavidin solution in phosphate buffered saline 0.01M pH 7.4 (PBS) overnight at room temperature. The substrates were then washed with water and saturated with a solution containing BSA 1% in PBS for 2 hours. After washing with water the devices were dried under nitrogen flow and used for the organic semiconductor deposition. Concentrations of streptavidin in the range 1-100 µg/ml were used to optimize capture protein immobilization. Immobilization of streptavidin by spin-coating was achieved by depositing a solution of streptavidin in water on Si/SiO₂ substrates, previously washed and activated, at a rate of 200 rpm until evaporation of the solvent was complete. Concentrations of streptavidin in the 1-100 µg/ml range were used to optimize capture protein immobilization. For the streptavidin chemical binding the washed and activated devices were functionalized with a 5% solution of 3-aminopropyltrietoxysilane (APTES) in ethanol. The functionalized devices were then treated with a 2.5% glutaraldehyde solution in PBS and subsequently, in order to obtain the binding of the protein, they reacted with a streptavidin solution in PBS. Next, optimization of capture protein immobilization is performed through luminescence imaging. The homogeneity of the immobilized biomolecule layer on sensor surface and the effect of organic solvents such as chloroform, used for deposition of the organic semiconductor on the protein layer, were valued by means of luminescence imaging techniques using the streptavidin - Alexa Fluor 488 fluorescent conjugate. The fluorescence images were acquired using a fluorescence microscope equipped with a CCD camera. The devices, on which protein recognition elements were immobilized, were subjected first to fluorescence analysis and subsequently to treatment with an organic solvent. The homogeneity of the deposited protein layer was evaluated by taking fluorescence images acquired for each immobilization procedures and for each concentration. Furthermore, the fluorescence images were acquired before and after treatment with chloroform to evaluate if the treatment with organic solvents (used for the deposition of the organic semiconductor on the biomolecule layer) modifies the structure of the immobilized protein. The images obtained by different immobilization techniques shows that the best results are obtained immobilizing the protein molecules through the spin-coating technique and chemical binding. In fact, a homogeneous protein layer is obtained with these two techniques and small covering imperfections are observable only at very high magnifications. Instead, in the case of immobilization by physical adsorption some inhomogeneous areas and dielectric portions not covered by the protein layer can be observed, even ay low magnifications. Such observations were also confirmed by electric measurements, in fact, the devices obtained by physical adsorption of the protein exhibited worse electric parameters. Concerning the protein concentration, in all cases, the best results were obtained using a concentration of 10 µg/ml. Such concentration is enough to assure an excess of capture protein so that all antigen molecules can react. Furthermore, working in excess of capture reagent assures that significant signal changes are not observed even in the case of small changes of protein immobilization efficiency. Furthermore, it must be pointed out that a fundamental aspect in the deposition of protein molecules is the dielectric layer hydrophilicity. Tests performed on devices not activated or made hydrophobic by treatment with hexamethyldisilazane (HMDS) showed an insufficient and inhomogeneous deposition of the protein layer. For all protein deposition methods, the fluorescence images obtained after treatment with chloroform highlighted that treatment with the organic solvent does not change the structure of the immobilized protein layer.

Analyte capability to pass through the layer of deposited organic semiconductor on the biological recognition element as well as the immobilized protein keeping its biological functionality were devalued by chemiluminescence reinforced by immobilizing the horseradish peroxidase enzyme (HRP) and the chemiluminescence system constituted by luminol/H₂O₂/p-iodophenol. The choice of the chemiluminescence technique was driven by the fact that luminol has a size comparable to that of biotin, then the development of light can be obtained only if this, or the other components of the substrate, pass through the organic semiconductor layer and if the HRP enzyme remains active. To perform the determination, a 100 µg/ml HRP solution in water was deposited by spin-coating on the washed and activated device SiO2 surface. After enzyme immobilization, the organic semiconductor was deposited and finally the chemiluminescence substrate was added. Chemiluminescence images were immediately acquired by a CCD camera. As a result of the chemiluminescence substrate addition it would be possible to observe a light signal only if the enzyme remains active and if the substrate components reach the immobilized enzyme passing through the semiconductor.

The chemiluminescence images were recorded on devices, on which HRP was deposited, before and after treatment with chloroform and after deposition of the organic semiconductor. From the images it is possible to observe that in all cases a light signal is visible, clearly indicating that the enzyme remains active and that the analyte, in this case luminol, is able to pass through the organic semiconductor. Further, this response demonstrates that the treatment which is necessary to device preparation keeps HRP enzyme functionality unchanged.

OFET devices (figure 1) can be employed as biosensors since, as a result of the specific interaction of the analyte with the biological molecules immobilized as previously described, a variation of the electric OTFT properties due to changes which take place in the organic semiconductor deposited on the bioactive material occurs. The sensing measurements were performed measuring also in this case the transistor transfer characteristics in the absence and in the presence of the analyte. Devices, in which the biological recognition element was not immobilized (then only P3HT), were used as negative control. Before the electric measurements the device was divided into two regions, a region was used as blank, in other words only water was added and a 10 µg/ml biotin solution in water was distributed on the other region. The transfer characteristics obtained for OFETs functionalized with streptavidin treated only with water, OFETs functionalized with streptavidin following the addition of biotin are displayed in figure 7. The other curves are measured on the negative control samples where the capture protein is not present. Streptavidin immobilization was always performed by spin-coating. The obtained results show how a much more evident current reduction is achieved in the positive sample respect to the negative one as a result of biotin addition (figure 7). Current reduction observed for the negative sample as a result of biotin addition can be ascribed to a weak unspecific interaction of the latter with the organic semiconductor. Anyway, properly optimized saturation procedures can be able to reduce such phenomenon. Seven different OFETs which are present on the same chip were tested to evaluate the intra-device variability. The results reported in table 1 show the very lower variability coefficient respect to the negative control, both for the blank and after biotin addition obtained in the case of the device functionalized with the biological recognition element.

**Table 1: In the table the mean values of the ID current calculated from the trans characteristics for VG = -39.5 after analysis of seven channels of the same device are reported. Further, the corresponding standard deviations (SD) and the percentage coefficients of variability (CV %) are reported.**

| Device | Mean (= 7) I_{D} for V_{G} =-39.5 | SD | CV % |
|---|---|---|---|
| P3HT / water | 0.65 µA | 0.07 | 10% |
| P3HT / biotin | 0.39 µA | 0.04 | 10% |
| STREP + P3HT / water | 0.60 µA | 0.03 | 5% |
| STREP + P3HT / biotin | 0.28 µA | 0.01 | 4% |

Such result is of noteworthy importance since it highlights how a significant improvement of sensor reproducibility occurs in presence of a specific recognition reaction. Further experiments on a high number of devices could evidence such result even with regard to the inter-device variability. Another parameter that can be used to determine the presence of the analyte is the threshold voltage Vt. In fact, values of 32.5 and 16.8 Volt respectively were obtained calculating the mean value of Vt in absence and presence of the analyte, for the different channels subjected to electric testing on a device in which streptavidin was immobilized. Instead, significant changes of Vt are not observed in the negative control. Such result could be explained considering that a change in the charge trapping properties of the OFET biosensor occurs in presence of the streptavidin-biotin complex. From the discussed preliminary results it is possible to understand how the developed biosensor is perfectly capable to discriminate the presence or not of the analyte. Further, from the calibration curve it is possible to determine the concentration of the analyte which is present in the sample too. The advantages of such a device, respect to other commercially available systems, are noteworthy. In fact, beyond the possibility to develop label-free immunosensors or genosensors, namely without the employment of luminescent or enzymatic tracers, the system coupling charge transport through field effect with the bio-sensing process allows to obtain high performances mainly in terms of sensitivity and bias control. Further, the response of these devices is electronic and then immediately available through a proper circuit. Beyond testing the already developed devices using different proteins as negative and positive control, for example bovine serum albumin (BSA) and anti-biotin antibodies, future developments could be directed even to integrate systems of microfluidics in the device for reagent distribution and to develop multianalyte systems. In this last case biospecific probes will be immobilized in different positions of the device, and the signals coming from the different points (corresponding to the binding of the specific analyte) will be detected separately. In this way, it will be possible to determine and quantify different analytes which are present on the same sample simultaneously. The employed technology will be that of the realization of an OFET array. It is then possible to consider the development of a new platform using the electronic sensors proposed in this invention employing different biological layers also in array (matrix) configuration. Such system would allow the detection of a multianalyte system and the manufacturing of these devices could be performed with technologies presently employed for organic electronics on a large scale. This aspect is particularly important in clinical diagnosis and in "Point Of Care" monitoring, in fact the devices to be developed could be used for the simultaneous detection of a groups of analytes related to a particular pathology. Further, disposable devices could be realized too, such format will allow to overcome the problem of biosensors regeneration. Furthermore, it will avoid the risk of cross-contamination between different samples and the danger of contamination linked to the handling of infected clinical samples.

The methods for OFET sensors realization with other proteins classes mentioned at point (b) as well as with the biological systems of which at points (d), (e) or (f) are depicted in scheme 1.

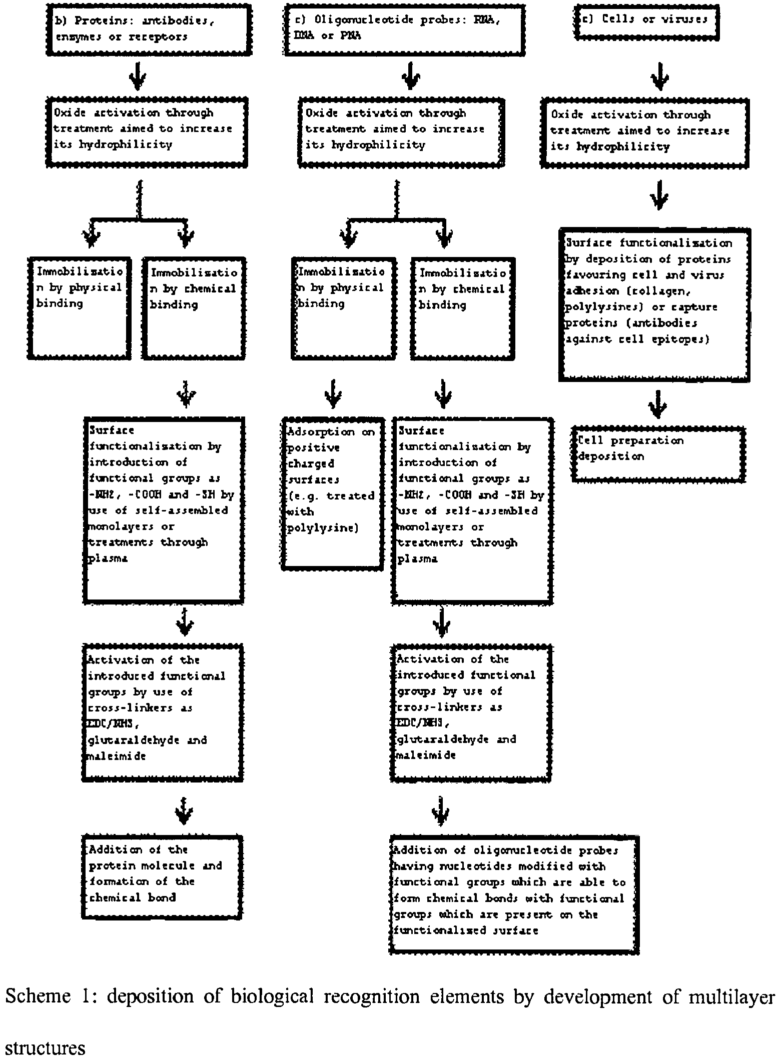

The produced experimental evidences demonstrate that:
Sensor 1: the OFET employing the layer (a) displays field effect and can work as a sensor of anaesthetics. The methods adopted for the realization of sensor 1 are readily extendible to the realization of a sensor comprising the biological system (c) which includes anyone of the proteins listed at point (b) or (f).
Sensor 2: the sensor employing a layer with one of the proteins listed at point (b), in particular streptavidin, displays current amplification and works as a sensor of biotin. The methods adopted for the realization of sensor 2 are readily extendible to OFETs realized with the other protein classes mentioned at point (b) as well as with the biological systems described at points (d), (e) or (f).

Both sensors can provide performances in line with the requirements of possible industrial applications.

## Claims

1. A transistor comprising a conductive layer (4), a dielectric layer (3) and a thin organic semiconductor layer (1), wherein:
a layer of biological material (2) is deposited directly on the surface of said dielectric layer (3),
said organic semiconductor layer (1) is deposited on top of said layer of biological material (2), said layer of biological material being a layer of a biological recognition system and being comprised between said dielectric layer and said organic semiconductor layer.

2. The transistor according to claim 1, in which said transistor is an organic field effect or thin film transistor (OFET).

3. The transistor according to claim 1 or 2, in which said layer of biological material (2) is constituted by:
single or double layers of phospholipids;
- layers made of proteins such as: receptors, antibodies, ionic channels and enzymes;
- single or double layers of phospholipids with inclusion or anchoring of protein such as: receptors,
antibodies, ionic channels and enzymes,
- layers made of oligonucleotide (DNA, RNA, PNA) probes;
- layers made of cells or viruses;
- layers made of synthetic receptors for example molecules or macromolecules similar to biological receptors for properties, reactivity or steric aspects.

4. The transistor according to one of claims 1 to 3, in which said layer of biological material (2) is covalently bound or attached, by physical adsorption or by means of other bindings and/or weak forces, or spin-coating to the dielectric layer (3).

5. The transistor according to any of the preceding claims, wherein said layer of biological material is covered by an organic semiconductor of type "p" or "n".

6. The transistor according to one or more of the preceding claims, wherein said organic semiconductor is poly(3-hexylthiophene-2,5-diyl).

7. The transistor according to any of the preceding claims, wherein the space in between the S and D contacts is comprised between 1 µm and 500 µm.

8. A sensor comprising a transistor according to any of the preceding claims, wherein analyte recognition occurs in a region of bidimensional charge transport, wherein the field effect which is responsible of current amplification is established.

## Patentansprüche

1. Transistor mit einer leitenden Schicht (4), einer dielektrischen Schicht (3) und einer dünnen organischen Halbleiterschicht (1), wobei:
eine Schicht aus biologischem Material (2) direkt auf der Oberfläche der dielektrischen Schicht (3) aufgetragen ist,
die organische Halbleiterschicht (1) über der Schicht aus biologischem Material (2) aufgetragen ist, wobei die Schicht aus biologischem Material eine Schicht aus einem biologischen Erkennungssystem zwischen der dielektrischen Schicht und der organischen Halbleiterschicht ist.

2. Transistor nach Anspruch 1, wobei der Transistor ein organischer Feldeffekt- oder Dünnfilmtransistor (OFET) ist.

3. Transistor nach Anspruch 1 oder 2, wobei die Schicht aus biologischem Material (2) gebildet wird durch:
- einzelne oder doppelte Schichten aus Phospholipiden,
- Schichten aus Proteinen wie etwa Rezeptoren, Antikörpern, lonenkanälen und Enzymen,
- einzelne oder doppelte Schichten aus Phospholipiden mit einem Einschluss oder einer Verankerung von Proteinen wie etwa Rezeptoren, Antikörpern, Ionenkanälen und Enzymen,
- Schichten aus Oligonukleotid (DNA, RNA, PNA)-Sonden,
- Schichten aus Zellen oder Viren,
- Schichten aus synthetischen Rezeptoren für zum Beispiel Moleküle oder Makromoleküle, die biologischen Rezeptoren hinsichtlich der Eigenschaften, der Reaktivität oder den sterischen Aspekten ähnlich sind.

4. Transistor nach einem der Ansprüche 1 bis 3, wobei die Schicht aus biologischem Material (2) durch eine physikalische Adsorption oder mittels anderer Bindungen und/oder schwacher Kräfte oder durch eine Rotationsbeschichtung auf die dielektrische Schicht (3) kovalent gebunden oder befestigt ist.

5. Transistor nach einem der vorstehenden Ansprüche, wobei die Schicht aus biologischem Material durch einen organischen Halbleiter des Typs "p" oder "n" bedeckt ist.

6. Transistor nach einem oder mehreren der vorstehenden Ansprüche, wobei der organische Halbleiter Poly(3-hexylthiophen-2,5-diyl) ist.

7. Transistor nach einem der vorstehenden Ansprüche, wobei der Zwischenraum zwischen den S- und D-Kontakten zwischen 1 µm und 500 µm beträgt.

8. Sensor mit einem Transistor nach einem der vorstehenden Ansprüche, wobei eine Analyterkennung in einem Bereich eines bidimensionalen Ladungstransports auftritt, durch den der für eine Stromverstärkung verantwortliche Feldeffekt hergestellt wird.

## Revendications

1. Transistor comprenant une couche conductrice (4), une couche diélectrique (3) et une couche semi-conductrice organique mince (1), dans lequel :
une couche de matériel biologique (2) est déposée directement sur la surface de ladite couche diélectrique (3),
ladite couche semi-conductrice organique (1) est déposée au-dessus de ladite couche de matériel biologique (2), ladite couche de matériel biologique étant une couche d'un système de reconnaissance biologique et étant comprise entre ladite couche diélectrique et ladite couche semi-conductrice organique.

2. Transistor selon la revendication 1, dans lequel ledit transistor est un transistor à effet de champ organique (OFET) ou un transistor à couche mince.

3. Transistor selon la revendication 1 ou 2, dans lequel ladite couche de matériel biologique (2) est constituée :
de couches simples ou doubles de phospholipides ;
- de couches constituées de protéines telles que : des récepteurs, des anticorps, des canaux ioniques et des enzymes ;
- des couches simples ou doubles de phospholipides avec inclusion ou ancrage de protéine telle que : des récepteurs, des anticorps, des canaux ioniques et des enzymes,
- des couches constituées de sondes d'oligonucléotides (ADN, ARN, ANP) ;
- des couches constituées de cellules ou de virus ;
- des couches constituées de récepteurs synthétiques par exemple des molécules ou des macromolécules ayant des propriétés, une réactivité ou des aspects stériques similaires à ceux des récepteurs biologiques.

4. Transistor selon l'une des revendications 1 à 3, dans lequel ladite couche de matériel biologique (2) est liée ou attachée de manière covalente, par adsorption physique ou au moyen d'autres liaisons et/ou forces faibles, ou par dépôt par centrifugation à la couche diélectrique (3).

5. Transistor selon l'une des revendications précédentes, dans lequel ladite couche de matériel biologique est recouverte d'un semi-conducteur organique du type « p » ou « n ».

6. Transistor selon l'une ou plusieurs des revendications précédentes, dans lequel ledit semi-conducteur organique est un poly(3-hexylthiophène-2,5-diyle).

7. Transistor selon l'une des revendications précédentes, dans lequel l'espace entre les contacts S et D est compris entre 1 µm et 500 µm.

8. Capteur comprenant un transistor selon l'une des revendications précédentes, dans lequel une reconnaissance d'analyte se produit dans une région de transport de charge bidimensionnel, où l'effet de champ qui est responsable de l'amplification de courant est établi.
